# EUROPEAN PATENT SPECIFICATION

(11) **EP 1 775 760 B1**
(45) Date of publication and mention of the grant of the patent: **20.01.2021**
(21) Application number: 05768338.5
(22) Date of filing: 02.08.2005
(51) Int. Cl.: H01L 21/301, H01L 21/52, B32B 7/06, H01L 21/683, H01L 21/48, H01L 21/58

(54) **WAFER PROCESSING TAPE**
WAFER-VERARBEITUNGSBAND
RUBAN DE TRAITEMENT DE PLAQUETTES

(30) Priority: 03.08.2004 JP 2004227028
(43) Date of publication of application: 18.04.2007
(73) Proprietor: The Furukawa Electric Co., Ltd., Tokyo 100-8322 (JP)
(72) Inventor: KITA, Kenji, C-W, Livingtown Iwasakidai, 2002, Aichi, 4700135 (JP); MORISHIMA, Yasumasa, c/o FURUKAWA ELECTRIC CO. LTD, Tokyo 1008322 (JP); ISHIWATA, Shinichi, c/o FURUKAWA ELECTRIC CO. LTD, Tokyo 1008322 (JP); YABUKI, Akira, c/o FURUKAWA ELECTRIC CO. LTD, Tokyo 1008322 (JP)
(74) Representative: Forstmeyer, Dietmar
(86) International application number: PCT/JP2005/014488
(87) International publication number: WO 2006/014000

(56) References cited:
- EP-A1- 1 724 320
- JP-A- 10 335 271
- JP-A- H10 335 271
- JP-A- 2002 158 276
- JP-A- 2003 007 646
- JP-A- 2003 142 505
- JP-A- 2003 173 994
- JP-A- 2003 206 457
- JP-A- 2003 206 457
- JP-A- 2004 186 429
- JP-A- 2005 048 039
- JP-A- 2005 048 039
- US-A1- 2002 048 906
- Takehiro Ozawa ET AL: "Adhesive Properties of Ultraviolet Curable Pressure-Sensitive Adhesive Tape for Semiconductor Processing (I) - Interpretation via Rheological Viewpoint", Furukawa Review, No. 20, 1 January 2001 (2001-01-01), pages 83-88, XP055614883, Retrieved from the Internet: URL:https://www.furukawa.co.jp/review/fr02 0/fr20_15.pdf [retrieved on 2019-08-23]
- "Advanced highly-functional material", 28 November 2001 (2001-11-28), Takashi KURATA, Tokyo page 97,

## Description

### TECHNICAL FIELD

The present invention relates to a dicing die bond tape (hereinafter also termed wafer-processing tape) that can be used for processing a wafer, in producing a semiconductor device, such as a silicon wafer.

### BACKGROUND ART

An assembling process of a semiconductor device, such as an IC or the like, comprises the steps of: cutting and separating (dicing) a semiconductor wafer and the like into respective chips, after patterning; mounting the chips on a substrate or the like; and sealing them with a resin or the like.

In the dicing step, a semiconductor wafer is adhered, and thus fixed, to a dicing die-bond tape in advance, and then it is diced into the shape of chip. In the subsequent mounting step, since an adhesive layer and a removable adhesive layer are configured so that they can peel off from each other, the diced chip to which an adhesive agent is attached, is peeled off (picked up) from the removable adhesive layer, and then fixed, for example, to a substrate by the adhesive agent for adhering and fixing, which agent has adhered to the chip.

Dicing die bond tapes used for the above purpose include tapes prepared by applying a filmy adhesive agent to the surface of a dicing tape, and integrating both, and tapes having a removable adhesive layer and an adhesive layer that are formed as one layer. Both of these types are required to have sufficient temporary adhesion strength so that the wafer is not peeled off from tape upon dicing, and they are also required to have peeling capability to be easily peeled off upon picking up.

Further, in the mounting step, sufficient adhesive strength is required among the chips or between the chip(s) and the substrate. There are proposed a variety of dicing die bond tapes.

These removable adhesive tapes enable a so-called direct die bonding for, after dicing, picking up a chip with an adhesive layer adhered on the back side of the chip, mounting the chip on a substrate or the like, and curing (hardening) and adhering the chip by heating or the like. By these removable adhesive tapes, the coating process of an adhesive agent can be omitted.

However, the filmy adhesive agent used for these dicing die bond sheets contains a lot of low-molecular-weight material, such as epoxy resins, and tends to be softer than, and inferior in machinability (cutting property) to, a removable adhesive layer used for usual dicing tapes. This, therefore, has such problems that many whisker-like scraps (swarf) and burrs of the filmy adhesive agent are occurred in dicing; inferior pickup is easily caused in a pickup step after dicing; and, inferior adhesion of chips in a process of fabrication of a semiconductor device, such as ICs, and defectives of, for example, ICs, are easily caused.

A dicing die bond tape is disclosed in JP2002158276 A.

A dicing tape comprising a base film and an adhesive layer is disclosed in JP2003007646 A. The tape includes a hardened viscoelastic layer between the base film and the adhesive layer to prevent chipping.

### BRIEF DESCRIPTION OF DRAWINGS

Fig. 1 is a schematic sectional view showing a state where a semiconductor wafer and a dicing frame are adhered to a dicing die bond tape according to an embodiment of the present invention.
Fig. 2 is a schematic sectional view showing a state where a semiconductor wafer and a dicing frame are adhered to a dicing die bond tape according to another embodiment of the present invention.

### DISCLOSURE OF INVENTION

The invention provides a dicing die bond tape as defined in claim 1 and a method of using the tape as defined in claim 6. Preferred embodiments are defined in the dependent claims.

Herein, the term "removable adhesive agent" means an agent capable of adhering and being removed after treatment by curing, while the term "adhesive agent" means an agent capable of adhering only. For example, the term "radiation-curable removable adhesive agent" means a removable adhesive agent capable of being removed or peeled by hardening by irradiation of radiation such as UV, after application of the removable adhesive agent to a wafer and the like.

Further, the term "adhesive layer" means a layer, which can be peeled off from the removable adhesive layer and remain adhered to a chip when a semiconductor wafer or the like is mounted and diced and then the chip is picked up, and which can be used as an adhesive when the chip is mounted on and fixed to a substrate or a lead frame.

Further, the term "removable adhesive layer" means a layer that has a lower peeling force with the target to be bonded than that of the adhesive layer, and that can be used for temporary adhesion.

Further, the term "peeling force" means a force needed for peeling the adhered surfaces apart, and can be determined according to the method as stipulated in JIS Z0237.

The wafer-processing tape of the present invention can be applied to a semiconductor wafer, such as a silicon wafer, to use it when a wafer is diced, and it exhibits such an advantageously effect to reduce whisker-like scraps or the like when the wafer is diced and to make it possible to obtain good cuttability. Further, as a dicing die bond tape, the present invention ensures that the semiconductor element and the adhesive layer can be easily peeled from the removable adhesive layer when wafer chips are picked up, allowing direct die bonding of semiconductor element.

### BEST MODE FOR CARRYING OUT THE INVENTION

According to the present invention, can be provided a wafer-processing tape used for processing a wafer, which tape is a dicing die bond tape for using to adhere and fix a wafer and the like for dicing, and which tape is excellent in cuttability upon dicing. In particular, according to the present invention, can be provided a dicing die bond tape, which is a semiconductor wafer dicing die bond tape that can be used in a bonding process of mounting a diced product on a lead frame or a semiconductor chip after dicing, and that is excellent in cuttability.

The present invention will be described in detail below.

The inventors of the present invention have made earnest studies to solve the above problem in conventional technique. As a result, we noted an intermediate resin layer to be provided between a substrate film and a removable adhesive layer. Specifically, we found that machinability upon dicing can be improved, by using, as the intermediate layer, a material having a storage elastic modulus larger than that of the removable adhesive layer at the temperature in dicing.

Embodiments according to the present invention will be hereinafter explained.

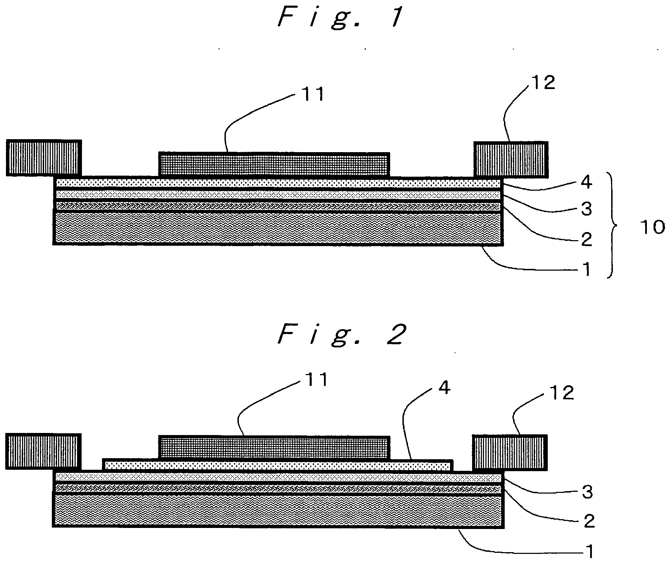

Fig. 1 is a schematic sectional view showing a state where a semiconductor wafer 11 and a dicing ring frame 12 are adhered to a dicing die bond tape 10 of the present invention.

The dicing die bond tape (10) of the present invention has the structure in which an intermediate resin layer 2, a removable adhesive layer 3 and an adhesive layer 4 are formed on a substrate film 1. Each layer may be cut (precut) into a specified shape in advance, according to working processes and apparatuses. The dicing die bond tape before a wafer and the like is adhered thereto, may be provided with a cover film to protect the adhesive layer or the removable adhesive layer.

The dicing die bond tape of the present invention may be cut into pieces in size of an individual wafer, or may be in a lengthy roll form.

Next, each structure of the dicing die bond tape of the present invention will be explained one by one.

### (Substrate film)

The substrate film constituting the dicing die bond tape of the present invention will be explained. As the substrate film, any of plastics or rubbers may be used, and it is not particularly limited. A plastic film having thermal plasticity is generally used as the substrate film. The material for the substrate film preferably has radiation transmittance, and particularly in the case of using a radiation-curable removable adhesive agent in the removable adhesive layer, it is preferable to select one having high radiation transmittance at the wavelength at which the removable adhesive agent is cured.

Examples of polymers which may be selected as the substrate include homopolymers or copolymers of α-olefins, such as polyethylene, polypropylene, ethylene/propylene copolymers, polybutene-1, poly-4-methylpentene-1, ethylene/vinyl acetate copolymers, ethylene/ethyl acrylate copolymers, ethylene/methyl acrylate copolymers, ethylene/acrylic acid copolymers, and ionomers, or mixtures of these compounds; engineering plastics, such as polyethylene terephthalate, polycarbonate, and poly(methyl methacrylate); thermoplastic elastomers, such as polyurethane, styrene/ethylene/butene or pentene-series copolymers, and polyamide/polyol copolymers, and mixtures of these compounds. Further, materials obtained by producing a multilayer from these compounds may be used.

Meanwhile, to increase the gap between elements, a film material which is as less as possible in necking (occurrence of partial elongation due to inferior propagation of power when the substrate film is stretched radially) is preferable. Examples of the material include polyurethanes, and styrene/ethylene/butene or pentene-series copolymers specified in molecular weight and styrene content. It is effective to use a crosslinked substrate film, to prevent elongation or deflection during dicing.

Further, the surface of the substrate film on which side the intermediate resin layer is formed, may be arbitrarily treated, for example, by carrying out a corona discharge treatment, or by forming a primer layer, to improve adhesiveness with the intermediate resin layer.

The thickness of the substrate film is generally 30 to 300 µm, from the viewpoint of strong elongation property and radiation transmittance. The surface of the substrate film on which surface no removable adhesive layer is applied, may be subjected to embossing or coated the surface with a lubricant, to thereby prevent blocking and to reduce friction between the removable adhesive tape and a jig when the removable adhesive tape is radially stretched, which is effective to prevent necking of the substrate film and is therefore preferable.

### (Intermediate resin layer)

The storage elastic modulus at 80°C of the intermediate resin layer is in the range 1 x 10⁵ to 5 x 10⁶ Pa, to suppress cracking and chipping of chips during dicing. Further, the storage elastic modulus at 25°C of the intermediate resin layer is preferably in the range from 1 × 10⁵ to 1 x 10⁶ Pa.

The intermediate resin layer can be formed, by applying a mixture containing a removable adhesive component and a curing component, to the surface of the substrate film, followed by curing. For the intermediate resin layer, it is preferable to use a material which is gradually cured to give an elastic modulus falling in a preferable range, when it is allowed to stand at ambient temperature for about one week.

Examples of a method of making a harder intermediate resin layer include, though not limited thereto, a method in which the glass transition point (Tg) of the removable adhesive component used as a main component (generally, the addition amount thereof is 60 to 98 mass% to the entire amount) is increased, a method in which an amount of a hardener to be added to the intermediate resin layer is increased, and a method in which an inorganic compound filler is added. Further, a material which is cured by irradiation of radiation may be used, and cured by irradiation of radiation, to control the hardness of the intermediate resin layer. Here, the term "radiation" means the generic name for the light, including ultraviolet rays, laser light, and ionizable radiation, such as electron rays (hereinafter referred to as radiation).

As the removable adhesive component, various common removable adhesive agents, such as an acryl type, polyester type, urethane type, silicone type or natural rubber type, may be used. In the present invention, particularly an acryl type removable adhesive agent is preferable. Examples of the acryl type removable adhesive agent include (meth)acrylate copolymers constituted of a (meth)acrylate monomer and a structural unit derived from a (meth)acrylic acid derivative. Here, as the (meth)acrylate monomer, cycloalkyl (meth)acrylate, benzyl (meth)acrylate, or alkyl (meth)acrylate in which the alkyl group has 1 to 18 carbon atoms, can be used. Further, examples of the (meth)acrylic acid derivative may include glycidyl (meth)acrylate having a glycidyl group, and hydroxyethyl acrylate having a hydroxyl group.

As the hardener, compounds selected from polyisocyanates, melamine/formaldehyde resins and epoxy resins, may be used either singly or in combination of two or more. This hardener works as a crosslinking agent; and the crosslinked structure resulting from the reaction of the hardener and the removable adhesive component such as an acrylic resin, brings about three-dimensional network structure of the intermediate resin layer, which is resistant to softening when the temperature is raised by dicing and the like.

Examples of the polyisocyanates include, though not particularly limited to, aromatic isocyanates, such as 4,4'-diphenylmethanediisocyanate, tolylenediisocyanate, xylylenediisocyanate, 4,4'-diphenyl ether diisocyanate, and 4,4'-[2,2-bis(4-phenoxyphenyl)propane]diisocyanate; hexamethylenediisocyanate, 2,2,4-trimethyl-hexamethylenediisocyanate, isophoronediisocyanate, 4,4'-dicyclohexylmethanediisocyanate, 2,4'-dicyclohexylmethanediisocyanate, lysinediisocyanate, and lysinetriisocyanate. Specifically, a commercially available product, such as Coronate L (trade name) and the like, may be used.

Further, as the melamine/formaldehyde resin, for example, commercial products, such as Nikarack MX-45 (trade name, manufactured by Sanwa Chemical Co., Ltd.), or Melan (trade name, manufactured by Hitachi Chemical Co., Ltd.), may be used.

As the epoxy resin, for example, TETRAD-X (trade name, manufactured by Mitsubishi Chemical Co., Ltd.), may be used.

Particularly, a polyisocyanate is preferably used in the present invention.

Further, the intermediate resin layer may be made to have radiation curability, to improve the pickup characteristics of chips by curing and shrinking the intermediate resin layer by radiation-curing after dicing.

Examples of a method of making the intermediate layer have radiation curability, include a method in which an acrylate type oligomer having a photopolymerizable carbon-carbon double bond is added. Further, as the above-mentioned oligomer, use can be widely made, for example, of any of low-molecular-weight compounds each having at least two photopolymerizable carbon-carbon double bonds in the molecule, which can exhibit a three-dimensional network by irradiation of light. More specifically, widely use can be made of, for example, trimethylolpropane triacrylate, tetramethylolmethane tetraacrylate, pentaerythritol triacrylate, pentaerythritol tetraacrylate, dipentaerythritol monohydroxypentaacrylate, dipentaerythritol hexaacrylate, 1,4-butyleneglycol diacrylate, 1,6-hexanediole diacrylate, polyethylenegrycol diacrylate, and an origoester acrylate.

As well as the above acrylate-series compounds, a urethane acrylate-series oligomer can also be used. The urethane acrylate-series oligomer can be obtained, by reacting a terminal isocyanate urethaneprepolymer that can be obtained by reaction of a polyol compound, e.g. a polyester-type or polyether-type, and a polyisocyanate compound (for example, 2,4-tolylenediisocyanate, 2,6-tolylenediisocyanate, 1,3-xylilenediisocyanate, 1,4-xylilenediisocyanate, diphenylmethane-4,4-diisocyanate), with a methacrylate or acrylate having a hydroxyl group (for example, 2-hydroxyethyl acrylate, 2-hydroxyethyl methacrylate, 2-hydroxypropyl acrylate, 2-hydroxypropyl methacrylate, polyethyleneglycol acrylate, polyethyleneglycol methacrylate).

When the intermediate resin layer is polymerized by radiation, a photopolymerization initiator, such as isopropyl benzoin ether, isobutyl benzoin ether, benzophenone, Michler's ketone, chlorothioxanthone, benzyl methyl ketal, α-hydroxycyclohexyl phenyl ketone, or 2-hydroxymethylphenylpropane, may be used together. It is possible to undergo the polymerization reaction effectively, by adding at least one type among these compounds to the intermediate resin layer.

To the intermediate resin layer, may be blended a temporary adhesion imparting agent, a temporary adhesion regulator, a surfactant, and other modifier, according to the need.

The thickness of the intermediate resin layer is preferably at least 5 µm, more preferably 10 µm or more. The intermediate resin layer may have a structure in which plural layers are laminated.

The intermediate resin layer applied to the substrate followed by curing may be composed of a heatcurable resin, to prevent the layer from being softened suddenly even at a temperature close to the dicing temperature, thereby bringing about good cuttability.

### (Removable adhesive layer)

After the intermediate resin layer is formed on the substrate film as mentioned above, the removable adhesive layer is further formed on the intermediate resin layer, to produce the dicing die bond tape of the present invention.

As to the formation of the removable adhesive layer, a removable adhesive agent is applied to the surface of the intermediate resin layer formed on the substrate film in the same manner as in the case of a usual dicing tape, to produce the removable adhesive layer. The removable adhesive agent may be applied at any time after the intermediate resin layer is applied. If the storage elastic modulus of the intermediate resin layer is controlled by irradiation with radiation, it is preferable to apply the removable adhesive layer after the intermediate resin layer is cured by radiation.

Any material may be used as the removable adhesive layer constituting the dicing die bond tape of the present invention, without any particular limitation insofar as it has retaining ability to the extent that prevents defects such as chip jumping between the removable adhesive layer and the adhesive layer during dicing from being occurred and as it has the characteristics that the removable adhesive layer is easily peeled from the adhesive layer upon picking up. In order to improve pickup characteristics after dicing, the removable adhesive layer is preferably a radiation curable type.

For example, in the present invention, it is preferable to use an acryl type removable adhesive agent containing: a compound (A) which has a radiation-curable carbon-carbon double bond of iodine value 0.5 to 20 in the molecule thereof; and at least one compound (B) which is selected from the group consisting of polyisocyanates, melamine/formaldehyde resins, and epoxy resins.

The compound (A), which is one of the main components of the removable adhesive layer, will be explained. The amount of the radiation-curable carbon-carbon double bond to be introduced in the compound (A) is preferably 0.5 to 20, more preferably 0.8 to 10, in terms of an iodine value. When the iodine value is 0.5 or more, the effect of reducing temporary adhesion strength after irradiation with radiation can be obtained. When the iodine value is 20 or less, the fluidity of the removable adhesive agent after irradiation with radiation is satisfactory, and it is therefore possible to obtain sufficient element gaps after stretching, making it possible to suppress the case of facing the problem that the image recognition of each element becomes difficult upon pickup. Further, the compound (A) itself has stability, bringing about production easiness.

The aforementioned compound (A) has a glass transition point of preferably -70°C to 0°C, more preferably -66°C to -28°C. When the glass transition point (hereinafter referred to as Tg) is -70°C or higher, sufficient heat resistance to the heat generated with irradiation with radiation is obtained. When the glass transition point is 0°C or lower, the effect of preventing elements from being scattered after dicing in a wafer having a coarse surface condition is obtained satisfactorily.

Although there is no particular limitation imposed on how to produce the above compound (A), as the compound (A), use may be made, for example, of one obtained, by reacting a compound ((1)), such as an acryl type copolymer or a methacryl type copolymer, which has a radiation-curable carbon-carbon double bond and a functional group, with a compound ((2)) having a functional group which can react with the above functional group.

Among these compounds, the above compound ((1)) having a radiation-curable carbon-carbon double bond and a functional group may be obtained, by copolymerizing a monomer ((1)-1), such as an alkyl acrylate or alkyl methacrylate, having a radiation-curable carbon-carbon double bond, with a monomer ((1)-2) having a functional group.

As the monomer ((1)-1), included are, for example, hexyl acrylate, n-octyl acrylate, isooctyl acrylate, 2-ethylhexyl acrylate, dodecyl acrylate, decyl acrylate, each having 6 to 12 carbon atoms, or monomers having 5 or less carbon atoms, such as pentyl acrylate, n-butyl acrylate, isobutyl acrylate, ethyl acrylate, and methyl acrylate, or methacrylates like these.

In this case of the monomer ((1)-1), as the number of carbon atoms of monomers increases, the glass transition temperature becomes lower, thereby enabling production of those of a desired glass transition temperature. Further, besides the glass transition temperature, for the purpose of enhancing compatibility and various performances, a low molecular compound having a carbon-carbon double bond, such as vinyl acetate, styrene, and acrylonitrile, can be blended within the range of 5% by mass or less to the total mass of the monomer ((1)-1).

Examples of the functional group which the monomer ((1)-2) has, include a carboxyl group, a hydroxyl group, an amino group, a cyclic acid anhydride group, an epoxy group, and an isocyanato group. Specific examples of the monomer ((1)-2) include acrylic acid, methacrylic acid, cinnamic acid, itaconic acid, fumaric acid, phthalic acid, 2-hydroxyalkyl acrylates, 2-hydroxyalkyl methacrylates, glycol monoacrylates, glycol monomethacrylates, N-methylol acrylamide, N-methylol methacrylamide, allyl alcohol, N-alkylaminoethyl acrylates, N-alkylaminoethyl methacrylates, acrylamides, methacrylamides, maleic anhydride, itaconic anhydride, fumaric anhydride, phthalic anhydride, glycidyl acrylate, glycidyl methacrylate, allyl glycidyl ether, and polyisocyanate compounds in which isocyanato groups are partially urethanated with a monomer having a hydroxyl group or carboxyl group and a radiation-curable carbon-carbon double bond.

In the compound (2), as a functional group to be used, in a case that the functional group in the compound (1), i.e. the monomer ((1)-2) is a carboxyl group or a cyclic acid anhydride group, included are a hydroxyl group, an epoxy group, an isocyanato group, and the like; or in a case that the functional group in the compound (1) is a hydroxyl group, included are a cyclic acid anhydride group, an isocyanato group, and the like; in a case that the functional group in the compound (1) is an amino group, included are an epoxy group, an isocyanato group, and the like; or in a case that the functional group in the compound (1) is an epoxy group, included are a carboxyl group, a cyclic acid anhydride group, an amino group, and the like. Specific examples of the functional group in the compound (2) include the same ones as those exemplified as the specific examples in the monomer ((1)-2).

A compound having the characteristics as to, for example, the acid value or hydroxyl group value, as preferably defined in the present invention can be produced, by leaving an unreacted functional group(s) in the reaction between the compound (1) and the compound (2).

In the synthesis of the above compound (A), when carrying out copolymerization reaction by solution polymerization, a ketone-series, ester-series, alcohol-series, or aromatic-series solvent can be used as an organic solvent. Among these, a preferable solvent is a usual good solvent for an acrylic-series polymer, which solvent has a boiling point of 60 to 120°C. Examples of the preferable solvent include toluene, ethyl acetate, isopropyl alcohol, benzene methylcellosolve, ethylcellosolve, acetone, methyl ethyl ketone, and the like. As a polymerization initiator, use may be generally made of a radical generating agent of azobis-series, such as α,α'-azobisisobutyronitrile, and organic peroxide-series, such as benzoylperoxide. At this time, a catalyst, a polymerization inhibitor, and the like can be optionally added, if necessary. In this way, it is possible to obtain the compound (A) with a desired molecular weight, by controlling a polymerization temperature and a polymerization time. As for the control of the molecular weight, it is preferred to use a mercaptan-series or carbon tetrachloride-series solvent. Additionally, this copolymerization is not limited to solution polymerization, but it may also be performed in other way such as bulk polymerization, suspension polymerization, and the like.

As mentioned in the above, the compound (A) can be obtained. In the present invention, the molecular weight of the compound (A) is preferably about 300,000 to about 1,000,000. If the molecular weight is too small, the cohesive force by irradiation of a radiation becomes lesser, thus a misalignment of elements (chips) may occur easily upon dicing the wafer, and image recognition may be difficult. Further, to prevent this misalignment of elements as much as possible, it is preferable that the molecular weight is 400,000 or more. If the molecular weight is too large, there is a possibility of gelation upon synthesis and coating.

When the compound (A) has an OH group giving a hydroxyl group value of 5 to 100, this can reduce temporary adhesion strength after irradiation of a radiation to thereby further reduce the risk of pickup miss, which is preferable. Further, the compound (A) preferably has a COOH group giving an acid value of 0.5 to 30.

In the meanwhile, if the hydroxyl group value of the compound (A) is too low, the temporary adhesion strength after irradiation of a radiation is not sufficiently reduced, or if too high, the flowability of the removable adhesive after irradiation of a radiation tends to be damaged. Further, if the acid value is too low, the tape recovery property is not sufficiently improved, or if too high, the flowability of the removable adhesive agent tends to be damaged.

The iodine value is calculated based on a Das method under the reaction condition of 40°C and 24 hours. The molecular weight is calculated as mass average molecular weight in terms of polystyrene, from the value measured by gel permeation chromatography (trade name: 150-C ALC/GPC, manufactured by Waters Company) by using a 1 % solution obtained by dissolving a sample in tetrahydrofuran. Further, the hydroxyl group value is calculated, according to an FT-IR method; and the acid value is calculated, according to JIS K 5407 11-1.

Next, the compound (B), which is another main component of the removable adhesive layer, will be explained. The compound (B) is a compound selected from polyisocyanates, melamine/formaldehyde resins, and epoxy resins, which may be used either singly or in combination of two or more. This compound (B) works as a crosslinking agent; and a crosslinking structure formed as a result of the reaction of the compound (B) with the compound (A) or the substrate film, can improve the cohesive force of the removable adhesive agent using the compounds (A) and (B) as its main components, after the removable adhesive agent is applied.

Examples of the polyisocyanates include, though not particularly limited to, aromatic isocyanates, such as 4,4'-diphenylmethanediisocyanate, tolylenediisocyanate, xylylenediisocyanate, 4,4'-diphenyl ether diisocyanate, and 4,4'-[2,2-bis(4-phenoxyphenyl)propane]diisocyanate; hexamethylenediisocyanate, 2,2,4-trimethyl-hexamethylenediisocyanate, isophoronediisocyanate, 4,4'-dicyclohexylmethanediisocyanate, 2,4'-dicyclohexylmethanediisocyanate, lysinediisocyanate, and lysinetriisocyanate. Specifically, a commercially available product, such as Coronate L, and the like, may be used.

Further, as the melamine/formaldehyde resin, for example, commercial products, such as Nikarack MX-45 (manufactured by Sanwa Chemical Co., Ltd.), or Melan (manufactured by Hitachi Chemical Co., Ltd.), may be used.

As the epoxy resin, for example, TETRAD-X (manufactured by Mitsubishi Chemical Co., Ltd.), may be used.

In the present invention, in particular, a polyisocyanate is preferably used.

The amount of the compound (B) to be added is preferably 0.1 to 10 parts by mass, more preferably 0.4 to 3 parts by mass, to 100 parts by mass of the compound (A). If the amount is too small, the effect of improving cohesive force tends to be insufficient; and if the amount is too large, operability tends to be impaired, since a curing reaction proceeds rapidly during the operation of compounding the removable adhesive agent and coating operation, resulting in formation of a crosslinking structure.

Further, in the present invention, the removable adhesive layer preferably contains a photopolymerization initiator (C). No particular limitation is imposed on the photopolymerization initiator (C) to be contained in the removable adhesive layer, and a conventionally known one may be used. Examples of the photopolymerization initiator (C) may include benzophenones, such as benzophenone, 4,4'-dimethylaminobenzophenone, 4,4'-diethylaminobenzophenone, and 4,4'-dichlorobenzophenone; acetophenones, such as acetophenone, and diethoxyacetophenone; anthraquinones, such as 2-ethylanthraquinone, and t-butylanthraquinone; 2-chlorothioxanthone, benzoin ethyl ether, benzoin isopropyl ether, benzyl, 2,4,5-triarylimidazole dimer (lophine dimer), and acridine type compounds. These compounds may be used either singly or in combination of two or more.

The amount of the compound (C) to be added is preferably 0.1 to 10 parts by mass, more preferably 0.5 to 5 parts by mass, to 100 parts by mass of the compound (A).

The radiation-curable removable adhesive agent that can be used in the present invention may be blended with a temporary adhesion imparting agent, a temporary adhesion regulator, a surfactant, and other modifier, according to the need. Further, an inorganic compound filler may be added arbitrarily.

The thickness of the removable adhesive layer is preferably at least 5 µm, more preferably 10 µm or more. The total thickness of the intermediate resin layer and the removable adhesive layer is preferably 15 µm or more and 50 µm or less, from the viewpoint of prevention of occurrence (in a large number) of whisker-like scraps on the tip surface or substrate. The removable adhesive layer may have a structure in which plural layers are laminated.

The storage elastic modulus at 80°C of the removable adhesive is in the range from 2 × 10⁴ to 5 × 10⁴ Pa.

### (Adhesive layer)

The dicing die bond tape of the present invention has a structure in which an adhesive layer is further formed to laminate on the dicing tape produced as mentioned in the above.

Further, herein, the term "adhesive layer" means a layer, which can be peeled off from the removable adhesive layer and remain adhered to a chip when a semiconductor wafer or the like is mounted and diced and then the chip is picked up, and which can be used as an adhesive agent when the chip is mounted on and fixed to a substrate or a lead frame. Any material may be used as the adhesive layer without any particular limitation insofar as it is a filmy adhesive agent which is usually used for dicing die bond tapes. The adhesive agent is preferably any of acrylic-series (removable adhesion or) adhesive agents, and blend type (removable adhesion or) adhesive agents, such as epoxy resin/phenol resin/acrylic resins. The thickness of the adhesive layer is preferably about 5 to 100 µm, though it may be arbitrarily set.

In the dicing die bond tape of the present invention, an adhesive layer which is made into a form of film in advance (hereinafter, referred to as an adhesive film), may be used as the adhesive layer; and it may be formed by laminating on the surface of the removable adhesive layer of the dicing die bond tape of the present invention which is provided with the aforementioned intermediate resin layer and the removable adhesive layer on the substrate. The lamination is preferably carried out at a temperature within the range from 10 to 100°C, by applying a linear pressure of 0.1 to 100 kgf/cm. In this case, as the adhesive agent film, a film formed on a separator may be used, and the separator may be peeled off after laminated or alternately may be used as it is as a cover film (carrier film) for the dicing die bond tape, but it is peeled from the tape when a wafer or the like is mounted. Further, though the adhesive film may be laminated on the entire surface of the removable adhesive layer, an adhesive film cut (precut) into a specified form corresponding to a wafer to be mounted in advance may be laminated. When the adhesive film corresponding to a wafer is laminated, it is preferable that the adhesive layer is applied to the removable adhesive layer upon using the dicing die bond tape of the present invention such that the adhesive layer is present at the portion where a wafer is to be mounted but is not present at the portion where a dicing ring frame is to be mounted. Generally, the adhesive layer evades peeling from a target to be mounted, and adhesive residue (i.e. the adhesive agent remained and adhered after peeling) onto the ring frame and the like is easily caused. The use of the precut adhesive film ensures that the ring frame can be adhered to the removable adhesive layer, to exhibit such an effect that adhesive residue onto the ring frame is scarcely caused when the used tape is peeled off.

The present invention will be described in more detail based on examples given below, but the invention is not meant to be limited by these. The "part(s)" means a part(s) by mass.

### EXAMPLES

### Examples 1 to 8, Comparative examples 1 to 4

Each intermediate resin layer composition, removable adhesive layer composition, and adhesive film were prepared in the following manner. Then, onto a 100-µm-thick ethylene/vinyl acetate copolymer film (substrate film), was applied the intermediate resin layer composition so that a dry film thickness would be one, as shown in Table 1, followed by drying at 110°C for 3 minutes, and then, on the resultant intermediate resin layer, was applied the removable adhesive layer composition so that a dry film thickness would be one, as shown in Table 1, followed by drying at 110°C for 3 minutes, thereby to produce removable adhesive tapes, respectively. The adhesive film was applied to any one of the removable adhesive tapes such that the adhesive layer would be laminated on the removable adhesive layer, to produce dicing die bond tapes (wafer-processing tapes) of Examples 1 to 8 and Comparative Examples 1 to 4, as shown in Table 1, respectively. The following characteristics of the resultant tapes were evaluated. When using the tape, the carrier film was peeled off from the adhesive film.

### Preparation of intermediate resin layer composition

### (Intermediate resin layer composition 1A)

100 parts by mass of an acrylic resin (mass average molecular weight 600,000, glass transition temperature -20°C), and 10 parts by mass of a polyisocyanate compound (trade name: Coronate L, manufactured by Nippon Polyurethane Industry Co., Ltd.) as a hardener, were mixed, to obtain an intermediate resin layer composition 1A.

### (Intermediate resin layer composition 1B)

100 parts by mass of an acrylic resin (mass average molecular weight 600,000, glass transition temperature -20°C), 30 parts by mass of an acrylate type oligomer having a photopolymerizable carbon-carbon double bond of iodine value 0.5 to 20 in the molecule as an oligomer, 1 part by mass of 2,2-dimethoxy-2-phenylacetophenone as a photopolymerization initiator, and 10 parts by mass of a polyisocyanate compound (trade name: Coronate L, manufactured by Nippon Polyurethane Industry Co., Ltd.) as a hardener, were mixed, to obtain a radiation-curable intermediate resin layer composition 1B.

### (Intermediate resin layer composition 1C)

100 parts by mass of an acrylic resin (mass average molecular weight 800,000, glass transition temperature -7°C), and 10 parts by mass of a polyisocyanate compound (trade name: Coronate L, manufactured by Nippon Polyurethane Industry Co., Ltd.) as a hardener, were mixed, to obtain a radiation-curable intermediate resin layer composition 1C.

### (Intermediate resin layer composition 1D)

100 parts by mass of an acrylic resin (mass average molecular weight 200,000, glass transition temperature -40°C), 100 parts by mass of an acrylate type oligomer having a photopolymerizable carbon-carbon double bond of iodine value 0.5 to 20 in the molecule as an oligomer, 1 part by mass of 2,2-dimethoxy-2-phenylacetophenone as a photopolymerization initiator, and 1 part by mass of a polyisocyanate compound (trade name: Coronate L, manufactured by Nippon Polyurethane Industry Co., Ltd.) as a hardener, were mixed, to obtain a radiation-curable intermediate resin layer composition 1D.

### Preparation of removable adhesive layer composition

### (Removable adhesive composition 2A)

To 400 g of toluene as a solvent, was added, dropwise, a mixture solution of 128 g of n-butyl acrylate, 307 g of 2-ethylhexyl acrylate, 67 g of methyl methacrylate, 1.5 g of methacrylic acid, and benzoylperoxide as a polymerization initiator, to react the mixture with arbitrarily controlling the amount to be added dropwise, and with controlling the reaction temperature and the reaction time, to obtain a solution of a compound (1) having a functional group.

Then, to the thus-obtained polymer solution, were added 2.5 g of 2-hydroxyethyl methacrylate synthesized separately from methacrylic acid and ethylene glycol, as a compound (2) having a radiation-curable carbon-carbon double bond and a functional group, and hydroquinone as a polymerization inhibitor, under a proper control of the amount to be added dropwise; and the mixture was reacted with controlling the reaction temperature and the reaction time, to obtain a solution of a compound (A) having a radiation-curable carbon-carbon double bond and having an iodine value, molecular weight and glass transition point, as shown in Table 1. Then, to the compound (A) solution, were added 1 part by mass of Coronate L (trade name, manufactured by Nippon Polyurethane Industry Co., Ltd.) as a polyisocyanate (B), 0.5 parts by mass of Irgacure 184 (trade name, manufactured by Ciba-Geigy Corp.) as a photopolymerization initiator, and 150 parts by mass of ethyl acetate as a solvent, to 100 parts by mass of the compound (A) in the compound (A) solution, to mix these thereby to prepare a radiation-curable removable adhesive composition 2A.

### (Removable adhesive composition 2B)

100 parts by mass of an acrylic resin (mass average molecular weight 600,000, glass transition temperature -20°C), and 10 parts by mass of a polyisocyanate compound (trade name: Coronate L, manufactured by Nippon Polyurethane Industry Co., Ltd.) as a hardener, were mixed, to obtain a removable adhesive composition 2B.

### Production of adhesive film

### (Adhesive film 3A)

To a composition of 50 parts by mass of a cresol novolac-type epoxy resin (epoxy equivalent 197, molecular weight 1,200, and softening point 70°C) as an epoxy resin, 1.5 parts by mass of γ-mercaptopropyltrimethoxysilane and 3 parts by mass of γ-ureidopropyltriethoxysilane as silane coupling agents, and 30 parts by mass of a silica filler of average particle diameter 16 nm, was added cyclohexanone, followed by stirring and mixing, and the resulting mixture was further kneaded using a beads mill for 90 minutes.

To the resultant reaction mixture, were added 100 parts by mass of an acrylic resin (mass average molecular weight 800,000, glass transition temperature -17°C), 5 parts of dipentaerythritol hexaacrylate as a hexafunctional acrylate monomer, 0.5 parts by mass of an adduct of hexamethylenediisocyanate as a hardener, and 2.5 parts by mass of Curesol 2PZ (trade name, manufactured by Shikoku Kasei (K.K.), 2-phenylimidazol), and these components were mixed with stirring, followed by deaerating under vacuum, to obtain an adhesive agent.

The resultant adhesive agent was applied onto a 25-µm-thick polyethylene terephthalate film which had been subjected to releasing treatment, followed by drying under heating at 110°C for 1 minute, to form a coating film having a film thickness of 40 µm and put in a B-stage state, thereby to produce an adhesive film 3A provided with a carrier film.

### (Adhesive agent 3B)

An adhesive film 3B was produced in the same manner as in the production of the adhesive film 3A, except that 50 parts by mass of a cresol novolac type epoxy resin (epoxy equivalent 197, molecular weight 1,200, and softening point 70°C) as the epoxy resin and 1 part of hexamethylene diisocyanate adduct as the hardener were used.

### (Adhesive agent 3C)

An adhesive film 3C was produced in the same manner as in the production of the adhesive film 3A, except that 0.5 parts by mass of hexamethylene diisocyanate adduct as the hardener was used and that 2.5 parts by mass of Curesol 2PHZ (trade name, manufactured by Shikoku Kasei (K.K.), 2-phenyl-4,5-dihydroxyimidazole) was used in place of Curesol 2PZ.

### Evaluation of the characteristics

Dicing die bond tapes of Examples 1 to 8 and Comparative Examples 1 to 4, as shown in Table 1, were produced, and the following characteristics were evaluated in the following manner: elastic moduluses at 25°C and 80°C of the intermediate resin layer, elastic modulus of the removable adhesive layer at 80°C, the number of whisker-like scraps on the surface of a chip and on the substrate, whether burrs of the adhesive agent were observed or not, the average value (µm) of chipping on the side surface, and pickup success rate (%).

### (Elastic modulus)

Each elastic modulus at 25°C or 80°C of the intermediate resin layer and the removable adhesive layer was measured in the following manner: a viscoelasticity meter (trade name: ARES, manufactured by Reometric Science Company) was utilized in measurement starting from 0°C, and a dynamic viscoelasticity was measured in the condition of temperature increase rate 5°C/min and frequency 1 Hz, in which the storage elastic modulus G' when the temperature reached 25°C or 80°C was defined as each elastic modulus.

In this case, as the intermediate resin layer and the removable adhesive layer to be measured, those obtained by standing for 14 days after produced were used.

### (The number of whisker-like scraps on the chip surface, and the number of whisker-like scraps on the substrate)

To any of the dicing die bond films obtained in Examples and Comparative Examples, a silicon wafer of thickness 100 µm and diameter 200 mm was adhered under heating in the condition of 70°C × 10 seconds, followed by dicing into chips of size 5 mm × 5 mm by using a dicing machine (trade name: DAD340, manufactured by Disco Company) at rotation number 40,000 rpm and cut speed 100 mm/sec. Thereafter, with respect to 100 chips in the center of the resultant silicon wafer, was counted the number of whisker-like scraps on the surfaces of these chips by microscopic observation, to determine the number of whisker-like scraps on the chip surface. Further, after the 100 chips to which the adhesive agent was transferred and adhered in the center of the silicon wafer, were peeled off, the number of whisker-like scraps on the tape was counted with respect to the 100 chips at the silicon wafer center portion, by microscopic observation, to determine the number of whisker-like scraps on the substrate.

### (Burrs of the adhesive agent whether they were observed or not)

To any of the dicing die bond films obtained in Examples and Comparative Examples, a silicon wafer of thickness 100 µm and diameter 200 mm was adhered under heating in the condition of 70°C × 10 seconds, followed by dicing into chips of size 5 mm x 5 mm by using a dicing machine (trade name: DAD340, manufactured by Disco Company) at rotation number 40,000 rpm and cut speed 100 mm/sec. Then, investigation was carried out by microscopic observation whether burrs of the adhesive agent were observed or not, with respect to the side surface of 20 chips in the center portion of the silicone wafer to which chips the die bond agent was transferred and adhered.

### (Side surface chipping)

To evaluate cracking and breaking (chipping) upon dicing, chipping on the side surface was measured in the following manner.

To any of the dicing die bond films obtained in Examples and Comparative Examples, a silicon wafer of thickness 100 µm and diameter 200 mm was adhered under heating in the condition of 70°C x 10 seconds, followed by dicing into chips of size 5 mm × 5 mm by using a dicing machine (trade name: DAD340, manufactured by Disco Company) at rotation number 40,000 rpm and cut speed 100 mm/sec. After diced into chips 5 mm x 5 mm in size, the size of chipping occurred on the side surface of 50 chips in the center portion of the silicon wafer after diced were observed, to determine an average value as the value of the side surface chipping. At this time, the size of the chipping was a size measured from the edge of the chip.

### (Pickup success rate)

To any of the dicing die bond films obtained in Examples and Comparative Examples, a silicon wafer of thickness 100 µm was adhered under heating in the condition of 70°C × 10 seconds, followed by dicing into chips of size 10 mm × 10 mm. Then, the removable adhesive layer was irradiated with ultraviolet rays from an air-cooling-type high-pressure mercury lamp (80 W/cm, illuminating distance 10 cm) at an intensity of 200 mJ/cm². Then, 50 chips in the center portion of the silicon wafer was subjected to a pickup test using a die bonder tester (trade name: CPS-100 FM, manufactured by NEC Machinery), to find the pickup success rate (%) based on the number of picked up chips per 50 chips. At this time, the case where the adhesive layer peeled from the removable adhesive layer was held by an element picked up was regarded as pickup success, to calculate the pickup success rate.

In each of Examples and Comparative examples, the elastic moduluses of the intermediate resin layer at 80°C and 25°C, the elastic modulus of the removable adhesive layer at 80°C, the number of whisker-like scraps on the chip surface and the substrate, the burrs of the adhesive agent if any, the average value (µm) of the side surface chipping, and the pickup success rate, were described collectively in Table 1.

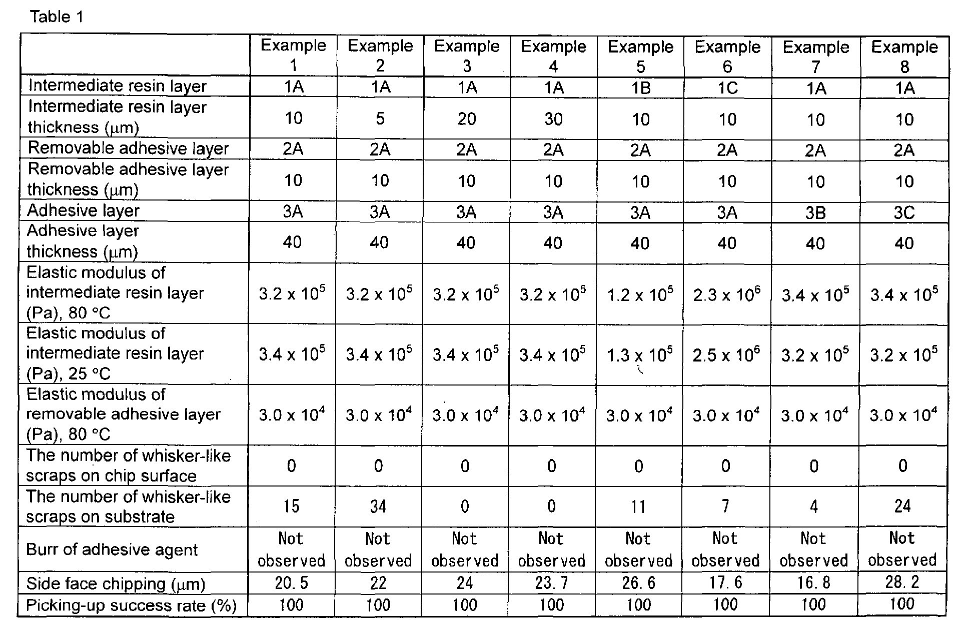

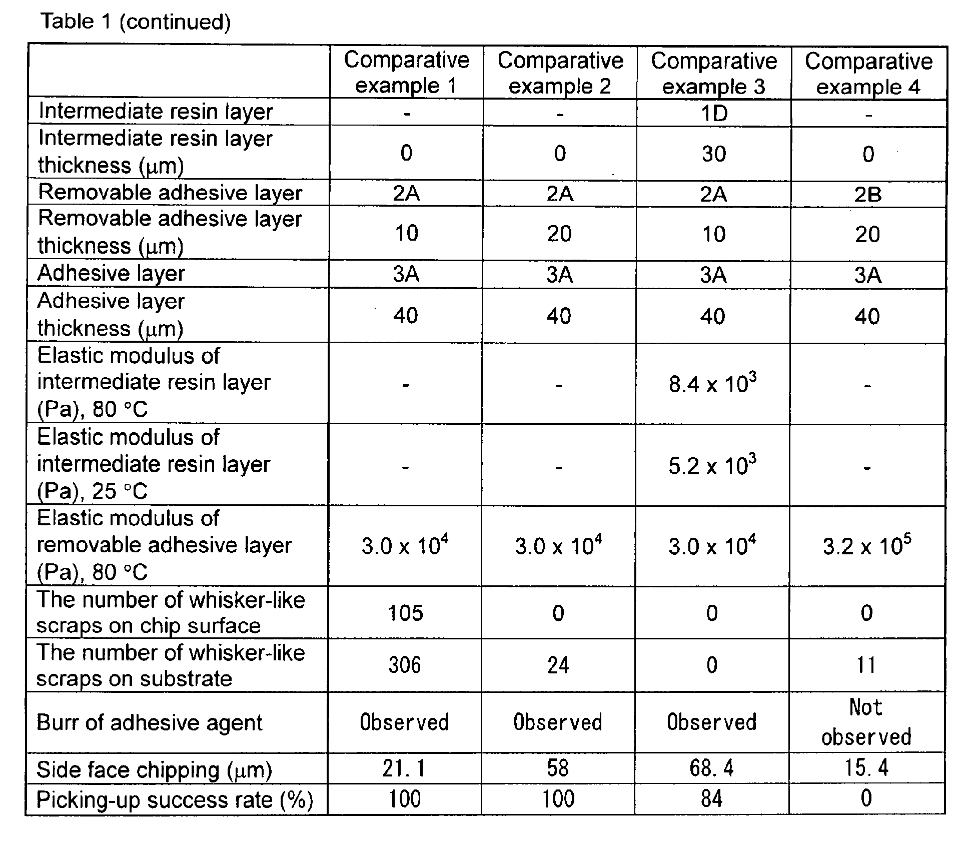

In the cases of using the tapes of Comparative Examples 1 and 2 provided with no intermediate resin layer, burrs of the adhesive agent were occurred upon dicing. In Comparative Example 1 which was provided with a thin removable adhesive layer, the number of whisker scraps on the chip surface and the substrate was considerably larger than that in Examples according to the present invention. Further, in Comparative Example 2 in which no intermediate resin layer was formed and only the thickness of the removable adhesive layer was increased, the side surface chipping was conspicuously increased. Further, in Comparative Example 3 using a softer material for the intermediate resin layer than the removable adhesive layer, burrs of the adhesive agent were occurred, the side surface chipping was conspicuously increased, and it was poor in the pickup success ratio. In Comparative Example 4 using only hard materials having a large elastic modulus for the removable adhesive layer, although no burrs of the adhesive agent were observed and the occurrence of whisker or chipping was less, picking-up of chips was impossible.

Contrary to the above, in Examples 1 to 8 according to the present invention, every characteristic of the above was excellent. Further, an IC chip of size 5 mm × 5 mm obtained by dicing a silicon wafer by using any of the dicing die bond tapes in Examples 1 to 8, was mounted directly on a lead frame by using a die bonder, followed by heating under the conditions at 170°C for 2 hours, as a result, it was confirmed that the lead frame was adhered firmly to the IC chip.

### (Other embodiments)

Fig. 2 is a schematic sectional view showing the state where a semiconductor wafer (11) and a dicing ring frame (12) are adhered to the dicing die bond tape according to other embodiment of the present invention. Like the case of Fig. 1, a dicing die bond tape (10) has a structure in which an intermediate resin layer 2, a removable adhesive layer 3, and an adhesive layer 4 are formed on a substrate film 1. As the adhesive layer 4, one precut in advance according to the shape of a semiconductor wafer, is laminated. The semiconductor wafer is mounted to the portion where the adhesive layer is present, but no adhesive layer is present at the portion where the ring frame is adhered, so that the ring frame is adhered to the removable adhesive layer.

In this embodiment, the ring frame can be adhered to the removable adhesive layer, exhibiting such an advantageous effect that adhesive residue onto the ring frame is scarcely caused when the used tape is peeled off.

### INDUSTRIAL APPLICABILITY

The wafer-processing tape of the present invention can be used as a dicing die bond tape ensuring good cuttability when dicing a semiconductor wafer.

Further, the wafer-processing tape of the present invention which is a dicing die bond tape, can be used as a dicing die bond tape that can pick up a chip together with the adhesive agent after dicing, and can be mounted directly on the lead frame or a substrate.

## Claims

1. A dicing die bond tape (10), comprising an intermediate resin layer (2), a removable adhesive layer (3) and an adhesive layer (4) which are laminated in this order on a substrate film (1),
wherein the removable adhesive layer is removable from the adhesive layer after a curing treatment,
wherein the storage elastic modulus at 80°C of the intermediate resin layer is in a range from 1 x 10⁵ to 5 x 10⁶ Pa, and wherein the storage elastic modulus (G') at 80°C of the removable adhesive layer is in a range from 2 x 10⁴ to 5 x 10⁴ Pa, wherein the storage elastic modulus (G') represents an elastic modulus when the temperature reaches 80°C in a measurement of a dynamic viscoelasticity starting from 0°C using a viscoelasticity meter, measuring in the condition of temperature increase rate 5°C/min and frequency 1 Hz.

2. The dicing die bond tape according to claim 1, wherein the storage elastic modulus (G') at 25°C of the intermediate resin layer is in a range from 1 x 10⁵ to 1 x 10⁶ Pa, wherein the storage elastic modulus (G') represents an elastic modulus when the temperature reaches 25°C in a measurement of a dynamic viscoelasticity starting from 0°C using a viscoelasticity meter, measuring in the condition of temperature increase rate 5°C/min and frequency 1 Hz.

3. The dicing die bond tape according to claim 1, wherein the intermediate resin layer is composed of an acryl type resin having a three-dimensional network structure.

4. The dicing die bond tape according to claim 1, wherein the intermediate resin layer is composed of a heatcurable resin.

5. The dicing die bond tape according to claim 1, wherein the removable adhesive layer contains: a compound (A), which has a radiation-curable carbon-carbon double bond of iodine value 0.5 to 20 in the molecule; and a compound (B), which is at least one selected from polyisocyanates, melamine/formaldehyde resins and epoxy resins.

6. Use of a dicing die bond tape according to any one of claims 1 to 5 in a bonding process comprising: adhering a wafer to the dicing die bond tape; dicing the wafer into chips while the dicing die bond tape is adhered to a dicing frame; and mounting a diced chip onto a lead frame or semiconductor chip or substrate,
wherein said dicing die bond tape comprises the intermediate resin layer and the removable adhesive layer which are laminated in this order on the substrate film, and further comprises the adhesive layer at least laminated in a portion to which the wafer is to be adhered, and no adhesive layer is provided in a portion to which the dicing frame is adhered,
wherein the adhesive layer remains adhered to the chip when the chip is picked up after dicing and is used as an adhesive when the chip is mounted on and fixed to 2. the substrate or the semiconductor chip or the lead frame.

7. A method of producing the dicing die bond tape according to any one of claims 1 to 5, wherein the intermediate resin layer is prepared by applying a mixture at least comprising an acryl type resin and a hardener to the substrate film, followed by curing.

## Patentansprüche

1. Klebeband zum Teilen von Chips (10), umfassend eine Harzzwischenschicht (2), eine entfernbare Klebeschicht (3) und eine Klebeschicht (4), die in dieser Reihenfolge auf einen Substratfilm (1) laminiert sind;
wobei die entfernbare Klebeschicht nach einer Härtungsbehandlung von der Klebeschicht entfernbar ist,
wobei der Speicherelastizitätsmodul bei 80 °C der Harzzwischenschicht in einem Bereich von 1 x 10⁵ bis 5 x 10⁶ Pa liegt und wobei der Speicherelastizitätsmodul (G') bei 80 °C der entfernbaren Klebstoffschicht in einem Bereich von 2 x 10⁴ bis 5 x 10⁴ Pa liegt, wobei der Speicherelastizitätsmodul (G') einen Elastizitätsmodul darstellt, wenn die Temperatur 80 °C bei einer Messung einer dynamischen Viskoelastizität ab 0 °C unter Verwendung von einem Viskoelastizitätsmesser erreicht, wobei unter der Bedingung einer Temperaturanstiegsrate von 5 °C/min und einer Frequenz von 1 Hz gemessen wird.

2. Klebeband zum Teilen von Chips nach Anspruch 1, wobei der Speicherelastizitätsmodul (G') bei 25 °C der Harzzwischenschicht in einem Bereich von 8 x 10⁵ bis 1 x 10⁶ Pa liegt, wobei der Speicherelastizitätsmodul (G') einen Elastizitätsmodul darstellt, wenn die Temperatur 25 °C bei einer Messung einer dynamischen Viskoelastizität ab 0 °C unter Verwendung eines Viskoelastizitätsmessers erreicht, wobei unter der Bedingung einer Temperaturanstiegsrate von 5 °C/min und einer Frequenz von 1 Hz gemessen wird.

3. Klebeband zum Teilen von Chips nach Anspruch 1, wobei die Harzzwischenschicht aus einem acrylartigen Harz mit einer dreidimensionalen Netzwerkstruktur zusammengesetzt ist.

4. Klebeband zum Teilen von Chips nach Anspruch 1, wobei die Zwischenharzschicht aus einem wärmehärtbaren Harz zusammengesetzt ist.

5. Klebeband zum Teilen von Chips nach Anspruch 1, wobei die entfernbare Klebeschicht enthält: eine Verbindung (A), die eine strahlungshärtbare Kohlenstoff-Kohlenstoff-Doppelbindung mit einem Iodwert von 0,5 bis 20 im Molekül aufweist; und eine Verbindung (B), die mindestens eine ist, ausgewählt aus Polyisocyanaten, Melamin/Formaldehyd-Harzen und Epoxidharzen.

6. Verwendung eines Klebebands zum Teilen von Chips nach einem der Ansprüche 1 bis 5 in einem Verbindungsverfahren, umfassend: Aufbringen eines Wafers auf das Klebeband zum Teilen von Chips,
Teilen des Wafers in Chips während das Klebeband zum Teilen von Chips auf einem Teilungsrahmen haftet; und Montieren eines geteilten Chips auf einen Leiterrahmen oder Halbleiterchip oder Substrat,
wobei das Klebeband zum Teilen von Chips die Zwischenharzschicht und die entfernbare Klebeschicht umfasst, die in dieser Reihenfolge auf dem Substratfilm laminiert sind, und ferner die Klebeschicht umfasst, die zumindest in einem Abschnitt laminiert ist, an dem der Wafer haften soll, und keine Klebeschicht in einem Abschnitt vorgesehen ist, an dem der Teilungsrahmenrahmen angebracht werden soll,
wobei die Klebstoffschicht am Chip haften bleibt, wenn der Chip nach dem Teilen aufgenommen wird, und als Klebstoff verwendet wird, wenn der Chip auf dem Substrat oder dem Halbleiterchip oder dem Leiterrahmen montiert und an diesem befestigt ist.

7. Verfahren zur Herstellung des Klebebands zum Teilen von Chips nach einem der Ansprüche 1 bis 5, wobei die HarzZwischenschicht durch Auftragen einer Mischung, umfassend mindestens ein acrylartiges Harz und einen Härter auf dem Substratfilm, gefolgt von Härten hergestellt wird.

## Revendications

1. Ruban de liaison pour découpage de plaquette (10), comprenant une couche de résine intermédiaire (2), une couche adhésive détachable (3) et une couche adhésive (4) qui sont stratifiées dans cet ordre sur un film de substrat (1),
dans lequel la couche adhésive détachable peut être détachée de la couche adhésive après un traitement de durcissement,
dans lequel le module d'élasticité au repos à 80 °C de la couche de résine intermédiaire est dans une plage allant de 1 x 10⁵ à 5 x 10⁶ Pa, et dans lequel le module d'élasticité au repos (G') à 80 °C de la couche adhésive détachable est dans une plage allant de 2 x 10⁴ à 5 x 10⁴ Pa, dans lequel le module d'élasticité au repos (G') représente un module d'élasticité quand la température atteint 80 °C dans une mesure d'une viscoélasticité dynamique partant de 0 °C en utilisant un appareil de mesure de viscoélasticité, mesurant dans la condition d'une vitesse d'augmentation de température de 5 °C/min et d'une fréquence de 1 Hz.

2. Ruban de liaison pour découpage de plaquette selon la revendication 1, dans lequel le module d'élasticité au repos (G') à 25 °C de la couche de résine intermédiaire est dans une plage allant de 1 x 10⁵ à 1 x 10⁶ Pa, dans lequel le module d'élasticité au repos (G') représente un module d'élasticité quand la température atteint 25 °C dans une mesure d'une viscoélasticité dynamique partant de 0 °C en utilisant un appareil de mesure de viscoélasticité, en mesurant dans la condition d'une vitesse d'augmentation de température de 5 °C/min et d'une fréquence de 1 Hz.

3. Ruban de liaison pour découpage de plaquette selon la revendication 1, dans lequel la couche de résine intermédiaire est composée d'une résine de type acrylique ayant une structure de réseau tridimensionnelle.

4. Ruban de liaison pour découpage de plaquette selon la revendication 1, dans lequel la couche de résine intermédiaire est composée d'une résine thermodurcissable.

5. Ruban de liaison pour découpage de plaquette selon la revendication 1, dans lequel la couche adhésive détachable contient : un composé (A) qui a une double liaison carbone-carbone durcissable par radiation d'un indice d'iode de 0,5 à 20 dans la molécule ; et un composé (B) qui est au moins un élément sélectionné parmi : polyisocyanates, résines mélamine/formaldéhyde et résines époxy.

6. Utilisation d'un ruban de liaison pour découpage de plaquette selon l'une quelconque des revendications 1 à 5 dans un processus de liaison comprenant les étapes suivantes:
faire adhérer une pastille au ruban de liaison pour découpage de plaquette ;
découper la pastille en puces pendant que le ruban de liaison pour découpage de plaquette est adhéré à un cadre de découpage ; et
monter une puce découpée sur un cadre conducteur, sur une puce semi-conductrice ou sur un substrat,
dans laquelle ledit ruban de liaison pour découpage de plaquette comprend la couche de résine intermédiaire et la couche adhésive détachable qui sont stratifiées dans cet ordre sur le film de substrat, et comprend en outre la couche adhésive au moins stratifiée dans une portion à laquelle la pastille doit être adhérée, et aucune couche adhésive n'est prévue dans une portion à laquelle le cadre de découpage est adhéré,
dans laquelle la couche adhésive reste adhérée à la puce quand la puce est prélevée après le découpage et est utilisée comme un adhésif quand la puce est montée sur et est fixée au substrat ou à la puce semi-conductrice ou au cadre conducteur.

7. Procédé de production du ruban de liaison pour découpage de plaquette selon l'une quelconque des revendications 1 à 5, dans lequel la couche de résine intermédiaire est préparée par application d'un mélange comprenant au moins une résine de type acrylique et un durcisseur sur le film de substrat, suivie du durcissement.
